Europäisches Patentamt

European Patent Office

Office européen des brevets

(11) Publication number: **0 146 198**
**A2**

# EUROPEAN PATENT APPLICATION

(21) Application number: **84303851.4**

(22) Date of filing: **07.06.84**

(51) Int. Cl.⁴: **H 03 K 17/96**

(30) Priority: **20.12.83 US 563592**

(71) Applicant: **CANNON DAVIS ASSOCIATES LIMITED, 121 Chertsey Road, Woking Surrey GU21 5BW (GB)**

(43) Date of publication of application: **26.06.85 Bulletin 85/26**

(72) Inventor: **Heinz, Peter, 12 Braybourne Drive Wood Lane, Osterley Isleworth Middlesex (GB)**

(74) Representative: **Colgan, Stephen James et al, CARPMAELS & RANSFORD 43 Bloomsbury Square, London WC1A 2RA. (GB)**

(84) Designated Contracting States: **AT BE CH DE FR GB IT LI LU NL SE**

(54) **Improvements in selector devices.**

(57) An electronic selector device has a control box (11) with conducting plates (13–22) secured to the inside of a window (12) in a building. Touching of the glass (12), or a conducting touch pad (23–32) on the outside of the window (12) causes a change in capacitance at that point, and an electronic pulse provided by a clock (40) is thereby delayed, causing triggering of a latch (61, 62) and consequent control of a display (10) or like apparatus.

EP 0 146 198 A2

ACTORUM AG

# IMPROVEMENTS IN SELECTOR DEVICES

The invention relates to electronic selector devices for allowing a user to select between certain options made available to him, and more particularly but not exclusively to electronic selector units for allowing selections of, for example, particular displays or information.

It is already known to have electronic selector devices having touch button control. A particular problem, however, arises where it is wished to display information or the like on apparatus which, for security reasons, is to be kept in a building or other enclosure, but which could be seen through a window in the building if a satisfactory selector control usable from outside were provided.

It is a primary object of this invention to provide an electronic selector device which can be operated from outside a building for controlling an information display unit, or similar device, within the building.

According to a first aspect of the invention, there is provided an electronic selector device comprising a plurality of discrete, identifiable conductors, such as conductive plates, adapted to be located against one side of a portion of a window, at least said portion being made of a dielectric material, such as glass, means for detecting a change in capacitance across said portion of the window, in the region of a particular conductor, when said portion is touched on the opposite side therefrom, and means for controlling associated apparatus in accordance with a signal produced by said capacitance change detecting means.

The invention further provides a glass window and a plurality of conductors secured at discrete, spaced apart positions to said window.

A plurality of conducting touch pads may be secured to the window on the side thereof remote from the conductors, each touch pad being opposite the associated conductor, thereby providing a set of capacitors, the window material being the dielectric between each touch pad and associated conductor.

The invention further provides an enclosure having a window, display apparatus within the enclosure and visible through the window, and a selector device according to the invention secured to the inside of the window, whereby the display can be controlled by touching the window.

The electronic capacitance change detecting means may comprise clock means to provide clock pulses and latch means responsive to said clock pulses to transfer an input signal to an output signal on any one of a plurality of respective inputs and outputs, the conductors or conductive plates attached to one side of said portion of the window or to one side of said window providing the respective input signals when touched.

Preferably means are provided to delay the clock pulse input to said latch means by a predetermined period, said predetermined period being greater than a delay due to the usual capacitance associated with said conductor or conductive plate, but less than a delay due to the capacitance associated with said conductor or conductive plate when the window portion is touched.

By way of example, one embodiment of an electronic selector device according to the invention will now be described with reference to the accompanying drawings, in which:-

Figure 1 illustrates schematically a display screen inside a window and a control panel with touch pads outside the window;

Figure 2 is a schematic side view of the apparatus of Figure 1; and

Figure 3 is a circuit diagram of an electronic circuit for the control system.

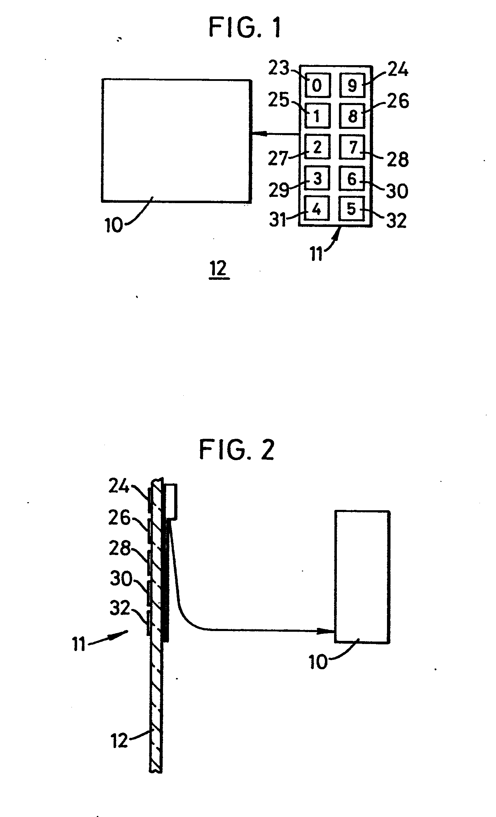

Figures 1 and 2 illustrate schematically a typical physical arrangement of a display 10 and a control box 11 to be operated by a user to control what is displayed on the display 10. The display 10 is inside a shop, office or the like, and therefore secure, and the contol box 11 is mounted on a window 12 of the building.

The control box 11 has 10 conducting plates 13 to 22 secured against the glass 12 on the inside of the building, each conducting plate 13 to 22 being spaced apart and electrically isolated from adjacent plates. The arrangement and number of plates 13 to 22 may be varied, but in the embodiment of figures 1 and 2, the plates are arranged in two vertical rows of five plates each.

Numbered, conducting touch pads 23 to 32 are secured to the glass 12 on the outside of the building. Each touch pad and its associated conducting plate form a capacitor with the glass 12 as dielectric. The touch pads are optional, but they tend to enhance accuracy and also encourage use of the system by the public who then have something to feel.

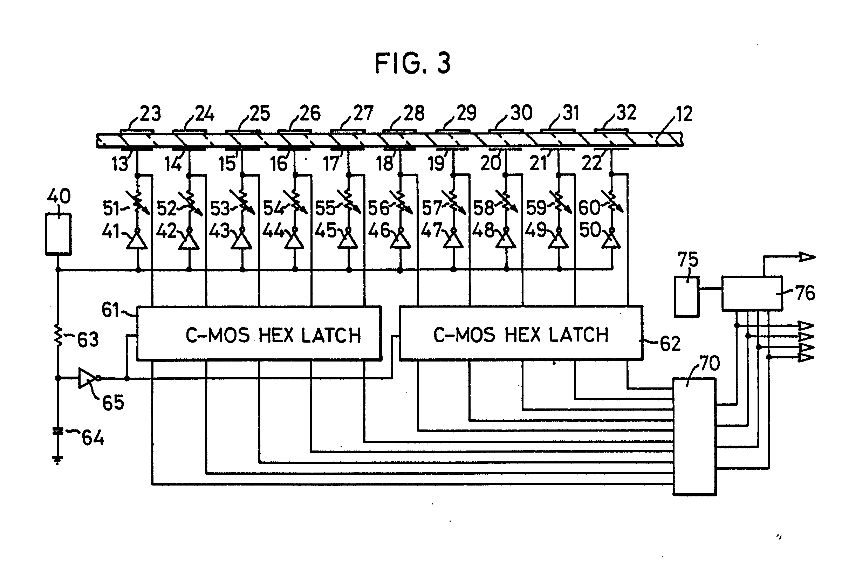

Operation of the touch pads causes operation of the display 10 in a desired manner by means of a control circuit shown in Figure 3.

In the control circuit, a clock 40 delivers regular clock pulses via an associated inverter 41 to 50 and an associated adjustable resistor 51 to 60 to each plate 13 to 22 and then to the date input of a C-MOS positive edge triggered latch 61, 62.

The same pulses are then slightly delayed by a resistor 63 and a capacitor 64 network and then applied to the clock input of the same latch via an inverter 65.

If no pad 23 to 32 is touched, the pulse delay resulting from the plate/touch pad capacitor and the adjustable resistor 51 to 60 leading to the data input is less than the delay reaching the clock input, so that when the latch 61, 62 is clocked the data input will be logically high and therefore the output "Q" will also be logically high.

As soon as a touch pad 23 to 32 is touched by a human hand the external side of the plate/touch pad capacitor is grounded and therefore the pulse leading to the data input of latch 61, 62 is delayed more than the pulse leading to the clock input of the latch 61, 62. Therefore, when the latch 61,62 is clocked the data input will still be logically low so that the output "Q" will also be logically low.

The output of the pad number touched is converted to Binary-Coded-Decimal in a decimal to Binary-Coded-Decimal converter 70 and then transmitted either in parallel or serial form to the receiving display unit 10 safely located inside the shop/showroom. Transmission in serial form is achieved in a manner well known per se by means of a clock 75 and a parallel to serial converter 76.

The window button selector unit described, enables the general public to inter-act from the street with a display device 24 hours a day even when the shop is closed without being able to access the actual display device in any other way.

CLAIMS

1.    An electronic selector device comprising a plurality of discrete,identifiable conductors (13-22) adapted to be located against one side of a portion of a window (12), at least said portion being made of a dielectric material, means (40-62) for detecting a change in capacitance across said portion of the window (12) in the region of a particular conductor when said portion is touched on the opposite side therefrom, and means for controlling associated apparatus in accordance with a signal produced by said capacitance change detecting means (42-62).

2.    An electronic selector device as claimed in Claim 1 wherein the electronic capacitance change detecting means (40-62) comprises clock means (40) to provide clock pulses and latch means (61,62) responsive to said clock pulses to transfer an input signal to an output signal on any one of a plurality of respective inputs and outputs, the conductors (13-22) attached to one side of said portion of the window (12) providing the respective input signals when touched.

3.    An electronic selector device as claimed in Claim 2 wherein means (63,64) are provided to delay the clock pulse input to said latch means (61,62) by a predetermined period, said predetermined period being greater  than a delay due to the usual capacitance associated with said conductor (13-22) but less than a delay due to the capacitance associated with said conductor (13-22) when the window portion is touched.

4.    A window (12) having secured thereto an electronic selector device according to Claim 1 or Claim 2 or Claim 3, said plurality of conductors (13-22) being secured to the window (12) at discrete, spaced apart positions.

5.    A window and selector device as claimed in Claim 4 comprising a plurality of conducting touch pads (23-52) secured to the window (12) on the side thereof remote from said conductors (13-22), each touch pad (23-32) being opposite the associated conductor (13-22) thereby providing a set of capacitors, the window material being the dielectric between each touch pad (23-32) and associated conductor (13-22).

6. An enclosure having a window, display apparatus (10) within the enclosure and visible through the window (12) and a selector device as claimed in Claim 1 or Claim 2 or Claim 3 secured to the inside of the window (12) whereby the display (10) can be controlled by touching the window.

## FIG. 1

23— 0    9 —24
25— 1    8 —26
    2    7 —28
27—
29— 3    6 —30
31— 4    5 —32

11

10

12

## FIG. 2

24—
26—
28—
30—
32—
11

10

12

# FIG. 3